# EUROPEAN PATENT APPLICATION

(11) **EP 0 736 810 A1**
(43) Date of publication of application: **09.10.1996**
(21) Application number: 95200884.5
(22) Date of filing: 07.04.1995
(51) Int. Cl.: G03F 7/30

(54) **Method for remotely monitoring operation of a lithographic printing plate processor**

(71) Applicant: AGFA-GEVAERT naamloze vennootschap, B-2640 Mortsel (BE)
(72) Inventor: De Backer, Jef, B-2640 Mortsel (BE); Claes, Jan, B-2640 Mortsel (BE)

(57) **Abstract**

The present invention provides a method for remotely monitoring and optionally adjusting operation of a lithographic printing plate processor (10), said processor comprising:
(i) developing station (12) for developing an image-wise exposed lithographic printing plate precursor according to silver salt diffusion transfer development;
(ii) washing station (14) for rinsing said lithographic printing plate precursor subsequent to development so as to obtain a printing plate having an image consisting of ink accepting silver containing areas on an ink repellant background;
(iii) finishing station (15) for improving the ink accepting property of said silver containing areas and/or the ink repellant property of said background;
(iv) means for detecting actual operating conditions of said developing station, washing station or finishing station;
(v) storing means (60,61) holding operating conditions of at least one of said developing station, washing station and finishing station;
(vi) means (100) for controlling operation of at least one of said developing station, rinsing station and finishing station based on said operating conditions stored in said storing means;
(vii) communication means (80) allowing for communication with a remote computing means (200);
said method comprising the steps of:
(a) establishing a communication between said lithographic printing plate processor and said computing means;
(b) retrieving said operating conditions stored in said storing means to said computing means and displaying said stored operating conditions;
(c) retrieving actual operating conditions to said computing means by retrieving the status of said detecting means;
(d) displaying said actual operating conditions and
(e) periodically repeating steps (c) and (d).

## Description

### 1. Field of the invention

The present invention provides a method for remotely monitoring and optionally adjusting operation of a lithographic printing plate processor, in particular a processor for processing a lithographic printing plate precursor according to the silver salt diffusion transfer process.

### 2. Background of the invention

The principles of the silver complex diffusion transfer reversal process, hereinafter called DTR-process, have been described e.g. in US-P 2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver halide solvent into soluble silver complex compounds which are allowed to diffuse into an image-receiving element and are reduced therein with a developing agent, generally in the presence of physical development nuclei, to form a silver image having reversed image density values ("DTR-image") with respect to the black silver image obtained in the exposed areas of the photographic material.

A DTR-image bearing material can be used as a planographic printing plate wherein the DTR-silver image areas form the water-repellant ink-receptive areas on a water-receptive ink-repellant background.

For example EP-A-410500 discloses a lithographic printing plate precursor, also called an imaging element hereinafter, containing an aluminium support provided with in the order given an image receiving layer containing physical development nuclei and a photosensitive layer containing a silver halide emulsion. According to the there disclosed method for obtaining a lithographic printing plate said imaging element is image-wise exposed and subsequently developed using a developing liquid or activating liquid in the presence of a silver halide complexing agent. The imaging element is then guided through a diffusion transfer zone so that the silver halide complexes formed during the development step are allowed to diffuse into the image-receiving layer where they are converted to silver. When the imaging element leaves the diffusion transfer zone a silver image is formed in the image receiving layer. The now useless photosensitive layer and optional other layers above the image receiving layer are then removed by rinsing the imaging element in a washing section. Finally the element now carrying a silver image on its surface is treated with a finishing liquid that contains so called hydrophobizing agents for improving the hydrophobicity of the silver image.

A lithographic printing plate precursor of the type as disclosed in EP-A-410500 is particular suitable for making printing plates to be used for printing newspapers, high quality print jobs, book printing etc.. Such printing jobs and in particular the printing of newspapers require a reliable processing of the lithographic printing plate precursors.

However, processing of an imaging element as described in EP-A-410500 requires a rather complicated processing involving at least three different processing sections and using three different processing liquids. Obviously, this increases the possibility of malfunction or of obtaining a printing plate not meeting the demands of the printing job. Often, the cause of such performance problem is not immediately apparent to the user who will then have to rely on a service engineer. Such service engineer may however not immediately be available and moreover often involves large expenses for both the customer and manufacturer or supplier of the equipement.

### 3. Summary of invention.

An object of the present invention is to provide a solution to aforementioned problems.

Further objects of this invention will become clear from the description hereinafter.

The present invention provides a method for monitoring and or adjusting operation of a lithographic printing plate processor as set out in the claims. Such method offers the advantage that the cause of a problem of bad performance of a printing plate or the malfunction of the processor can be found without the need for immediately sending a service engineer. Furthermore, it offers the possibility of remotely performing maintenance of the processor thereby increasing the reliability of the processor with a minimum of cost.

### 4. Brief description of the drawings

The invention will now be described in detail with reference to the following drawing illustrating the invention without the intention to limit the invention thereto:

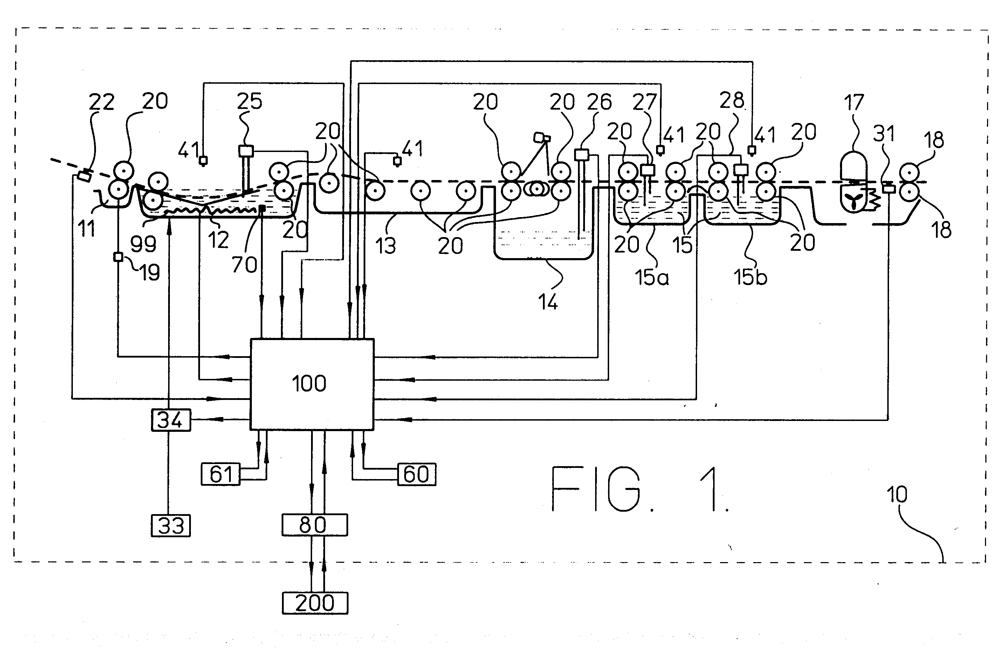

Figure 1 shows a schematic drawing of a lithographic printing plate processor 10 in accordance with the invention.

### 5. Detailed description of the invention.

With reference to figure 1 there is illustrated a longitudinal cross-section through a lithographic printing plate processor 10 (abbreviated processor hereinafter) for processing lithographic printing plate precursors particular of the type as disclosed in EP-A-410500.

EP-A-410500 discloses an imaging element containing an aluminium support provided with, in the order given, an image receiving layer containing physical development nuclei and a photosensitive layer containing a silver halide emulsion. According to the there disclosed method for obtaining a lithographic printing plate said imaging element is image-wise exposed and subsequently developed using a developing liquid or activating liquid in the presence of a silver halide complexing agent. The imaging element is then guided through a diffusion transfer zone so that the silver halide complexes formed during the development step are allowed to diffuse into the image-receiving layer where they are converted to silver. When the imaging element leaves the diffusion transfer zone a silver image is formed in the image receiving layer. The now useless photosensitive layer and optional other layers above the image receiving layer are then removed by rinsing the imaging element in a washing section. Finally the element now carrying a silver image on its surface is treated with a finishing liquid that contains so called hydrophobizing agents for improving the hydrophobicity of the silver image.

In the above described method for obtaining an aluminium based lithographic printing plate according to the DTR-process at least 3 different liquids are used i.e. a developing or activating liquid, a rinsing liquid, conveniently plain water and a finishing liquid.

The processor 10 is mounted within a generally rectangular housing which may include a rectangular metal frame (not shown) for supporting the various parts of the processor. The processor comprises a sheet feeding means 11, preferably a pair of rollers 20, a developing station 12, a diffusion transfer zone 13, a wash station 14, a finishing station 15, a drier 17 and a pair of output rollers 18. All the stations are linked by a single drive screw (not shown) so that all stations's rollers can operate simultaneously at the same speed.

According to the most preferred embodiment of the present invention, the liquids of the developing station, wash station and finishing station are automatically replenished and kept at a predetermined temperature. For convenience the controlling of a station with regard to replenishment, maintance of liquid levels and temperature of the liquid is only described in detail for the developing station.

Processor 10 includes a control means 100, which can be a central processing unit, receiving input from liquid level detectors 25 (developing station), 26 (wash station) , 27 and 28 (finishing station). Control means 100 further receives input from temperature sensors such as for example a temperature sensor 70 detecting the liquid temperature of the developing station. Control means 100 receives input from storing means 60, for example a memory chip, holding operating conditions of one or more stations. Such operating conditions preferably include a temperature setting and minimum and maximum liquid levels.

Control means 100 controls a clutch means 19 driving rollers 20 upon feeding of a lithographic printing plate precursor. The clutch means 19 is preferably an electromagnetic clutch.

Replenishment and temperature of the developing liquid is controlled by controlling means 100 by retrieving the minimum and maximum liquid levels and temperature setting of the developing liquid from storing means 60. Control means 100 controls a pump 34 pumping fresh developing liquid from liquid container 33 into the developing tank of the developing station. Pump 34 will be engaged by control means 100 when liquid level detector 25 signals a liquid level below the predetermined minimum level stored in storing means 60 and pump 34 will be switched off by control means 100 when detector 25 signals that the maximum level stored in storing means 60 is reached.

Preferably, storing means 60 includes a setting indicating the maximum time that may lapse between the start of pumping and the detection that the maximum level has been reached. Such time setting will allow for the detection of problems with the pumping of the development liquid which may be caused by an empty container 33 or a malfunction of pump 34. To descriminate between these two causes, a detector connected to control means 100 may be provided for detecting the liquid level in container 33.

Control means 100 further switches heating means 99, preferably heat exchange elements, on when the temperature of the developing liquid, as detected by temperature sensor 70, is below the stored temperature setting for the developing station. Control means 100 will switch heating means 99 off when the stored temperature is reached or is almost reached, taking into account temperature equilibration of the liquid.

Preferably, storing means 60 includes a setting indicating the maximum time that may lapse between the start of heating and reaching the desired temperature. Such setting can be used by control means 100 to detect a problem with heating means 99. As a further alternative, storing means 60 may include a setting for a ratio of an expected temperature increase to a unit of time (ΔT/Δt). Such setting would allow a more rapid detection of a heating problem.

The wash station and finishing station are preferably controlled in a similar way as the developing station. According to a further preferred embodiment, the temperature of the drier is also controlled by controlling means 100 using a corresponding operating condition stored in storing means 60.

Preferably, control means 100 is connected to a further storing means 61 to which control means 100 can store information with regard to the operation of processor 10. Preferably such storing means 61 will keep a record of the amount of material processed, consumed amount of the developing liquid, rinsing liquid and finishing liquid. Storing means 61 may further contain information with regard to time that has lapsed between maintenances and in particular may store error conditions that have occured during operation. Storing means 61 and 60 may be combined into one storing means.

Control means 100 can be connected to computing means 200 via a connection means 80. Preferably, such connection means will be a serial port, e.g. a RS232 communication port, that can be connected to a modem. Computing means 200 preferably is a computer having a central processing unit, e.g. an Intel™ 80386 processor, a keyboard and a display. Such computer further has a modem such that it can be connected to a public phone service via which communication can be established with the connection means 80 of processor 10.

Upon establishing communication between computing means 200 and processor 10, control means 100 of the processor can remotely be instructed by computing means 200 to retrieve settings stored in storing means 60 and optionally 61 and to communicate these to computing means 200. Further, computing means 200 will periodically retrieve, via control means 100, the status of the liquid level and temperature detectors. The thus retrieved information will then be displayed on the display of computing means 200.

The operation of processor 10 can further be monitored while a lithographic printing plate precursor is guided through the processor. Conveniently, transportation of the precursor is monitored by retrieving the signals from detectors 22, 41 and 31.

According to a particular advantage of the present invention, computing means 200 may be used to remotely change one or more settings stored in storing means 60 so as to effectively change the operation of one or more stations. Further, computing means 200 may instruct control means 100 to ignore signals from one or more detectors allowing for interactively diagnosing a problem in the operation of the processor 10. By actively modifying the operation of the processor 10 it was found that several causes of bad performance of the obtained printing plate could quickly be found and resolved.

## Claims

1. Method for remotely monitoring and optionally adjusting operation of a lithographic printing plate processor, said processor comprising:
(i) developing station for developing an image-wise exposed lithographic printing plate precursor according to silver salt diffusion transfer development;
(ii) washing station for rinsing said lithographic printing plate precursor subsequent to development so as to obtain a printing plate having an image consisting of ink accepting silver containing areas on an ink repellant background;
(iii) finishing station for improving the ink accepting property of said silver containing areas and/or the ink repellant property of said background;
(iv) means for detecting actual operating conditions of said developing station, washing station or finishing station;
(v) storing means holding operating conditions of at least one of said developing station, washing station and finishing station;
(vi) means for controlling operation of at least one of said developing station, rinsing station and finishing station based on said operating conditions stored in said storing means;
(vii) communication means allowing for communication with a remote computing means;
said method comprising the steps of:
(a) establishing a communication between said lithographic printing plate processor and said computing means;
(b) retrieving said operating conditions stored in said storing means to said computing means and displaying said stored operating conditions;
(c) retrieving actual operating conditions to said computing means by retrieving the status of said detecting means;
(d) displaying said actual operating conditions and
(e) periodically repeating steps (c) and (d).

2. A method according to claim 1 wherein said lithographic printing plate processor comprises means for detecting actual operating conditions of said developing station, rinsing station and finishing station, storing means for holding operating conditions of said developing station, rinsing station and finishing station and controlling means for controlling said developing station, rinsing station and finishing station based on said operating conditions stored in said storing means.

3. A method according to claim 1 or 2 wherein said developing station, rinsing station and finishing station each include a tank holding liquid and a detecting means for detecting the level of said liquid in said tank.

4. A method according to claim 3 wherein said developing station, rinsing station and/or finishing station comprise a heating means and a detecting means for detecting the temperature of said liquid in said tank.

5. A method according to claim 3 wherein said storing means contains minimum and/or maximum liquid levels for each of said developing station, rinsing station and finishing station.

6. A method according to claim 4 wherein said storing means comprises a temperature setting for said developing station, rinsing station and/or finishing station.

7. A method according to claim 1 wherein said lithographic printing plate processor further comprises detecting means for detecting transportation of said lithographic printing plate precursor through said lithographic printing plate processor, the status of said detecting means being retrieved and displayed on said computing means during processing of a lithographic printing plate precursor.

8. A method according to claim 1 wherein new operating conditions for at least one of said developing station, rinsing station and finishing station are stored into said storing means by said computing means.

9. A lithographic printing plate processor comprising a developing station (12), washing station (14) and finishing station (15) characterised in that said lithographic printing plate processor further comprises a control means (100), liquid level detecting means (25,26,27,28) and temperature detecting means (70) connected to said control means (100), storing means (60) connected to said control means (100) and communication means (80) connected to said control means (100).
